(19) Europäisches Patentamt
European Patent Office
Office européen des brevets

(11) **EP 1 610 139 A1**

(12) **EUROPEAN PATENT APPLICATION**
published in accordance with Art. 158(3) EPC

(43) Date of publication:
**28.12.2005 Bulletin 2005/52**

(51) Int Cl.7: **G01R 31/36**

(21) Application number: **04722654.3**

(86) International application number:
**PCT/JP2004/003913**

(22) Date of filing: **23.03.2004**

(87) International publication number:
**WO 2004/088340 (14.10.2004 Gazette 2004/42)**

(84) Designated Contracting States:
**AT BE BG CH CY CZ DE DK EE ES FI FR GB GR HU IE IT LI LU MC NL PL PT RO SE SI SK TR**
Designated Extension States:
**AL LT LV MK**

(30) Priority: **31.03.2003 JP 2003097464**

(71) Applicant: **YAZAKI CORPORATION**
**Minato-ku Tokyo 108-8333 (JP)**

(72) Inventors:
• **ARAI, Youichi, Yazaki Corporation**
  **Shizuoka 410-1194 (JP)**
• **MIKAMI, Hiroshi, Yazaki Corporation**
  **Shizuoka 410-1194 (JP)**

(74) Representative: **Viering, Jentschura & Partner**
**Steinsdorfstrasse 6**
**80538 München (DE)**

(54) **BATTERY STATE MONITORING DEVICE AND ITS METHOD, AND DISCHARGEABLE CAPACITY DETECTING METHOD**

(57)    A microcomputer 23 monitors a dischargeable capacity corresponding to a value by subtracting a capacity not to be discharged caused by an internal resistance of a battery from a charge capacity of the battery 13 based on outputs of a current sensor 15 and a voltage sensor 17.

FIG. 1

EP 1 610 139 A1

**EP 1 610 139 A1**

**Description**

BACKGROUND OF THE INVENTION

Field of the Invention

This invention relates to a battery condition monitor and a method of monitoring a battery condition, and a method of detecting a dischargeable capacity of a battery.

Description of the Related Art

A battery installed in a vehicle, especially in an electric vehicle having a motor as only one driving source, corresponds to gasoline of a vehicle in which a usual engine is applied to a driving source. Therefore, recognizing how much the battery is charged is very important to insure normal driving of the vehicle.

Usually, to recognize how much the battery is charged, a voltage at an open circuit of the battery is detected or SOC (State Of Charge) as following is detected by the voltage at the open circuit.

$$SOC[\%]=\{(OCVn - OCVe)/(OCVf - OCVe)\}*100$$

herein, OCVn is a voltage at the open circuit of the current battery. OCVf is a voltage at the open circuit of the battery in a full-charged condition. OCVe is a voltage at the open circuit of the battery in an ended discharge condition, and the battery cannot be used under the voltage at the open circuit.

SUMMARY OF THE INVENTION

Objects to be solved

The SOC corresponds to an electric charge (Coulomb energy) stored in the battery. In actual use, all of the electric charge cannot be used. It is caused by a voltage drop, which is generated by an internal resistance of the battery when a charging current flows. The internal resistance is caused by a DC resistance, concentration polarization and activation polarization of the battery. A value of the voltage drop is changed by SOC[%], a value of discharging current, a discharging time and a temperature. With accordance to a larger value of the voltage drop, a dischargeable electric charge becomes smaller.

Since, in usual SOC[%], the value of the voltage drop is not compensated, before SOC becomes zero by OCVn becoming equal to OCVe, a terminal voltage of the battery at discharging goes down under OCVe and the battery becomes not dischargeable. Therefore, a margin for the SOC should be considered. However, the margin for the SOC is not logical, so that the batter condition cannot be monitored securely by monitoring only the SOC.

To overcome the above problem, objects of the present invention are to provide a battery condition monitor, which can monitor a battery condition securely and a method of monitoring the battery condition, and a method of detecting a dischargeable capacity of a battery for monitoring the battery condition securely in cases including applying it to the monitor and the method.

How to attain the object of the present invention

In order to attain the object, a battery condition monitor for monitoring a condition of a battery according to claim 1 of the present invention monitors a capacity not to be discharged caused by an internal resistance of the battery.

A battery condition monitor for monitoring a condition of a battery according to claim 2 of the present invention includes a dischargeable capacity detector for detecting a dischargeable capacity corresponding to a value of subtracting a capacity not to be discharged caused by an internal resistance of the battery from a charged capacity, and monitors the condition of the battery based on the detected dischargeable capacity.

A battery condition monitor for monitoring a condition of a battery according to claim 3 of the present invention includes a charged capacity detector for detecting a charged capacity, and a dischargeable capacity detector for detecting a dischargeable capacity corresponding to a value of subtracting a capacity not to be discharged caused by an internal resistance of the battery from a charged capacity, and monitoring the condition of the battery based on the detected charged capacity and the detected dischargeable capacity.

A battery condition monitor for monitoring a condition of a battery according to claim 4 of the present invention is specified in the battery condition monitor as claimed in claim 1 or 2 in that the dischargeable capacity detector obtains the dischargeable capacity based on a value of subtracting a voltage drop caused by the internal resistance during discharging from an open-circuit voltage at start of discharging corresponding to discharging the battery.

A battery condition monitor for monitoring a condition of a battery according to claim 5 of the present invention is specified in the battery condition monitor as claimed in claim 4 in that the dischargeable capacity detector obtains the dischargeable capacity by making allowance for a changing value of a characteristics of a charging condition of the battery and the open-circuit voltage caused by deterioration.

A battery condition monitor for monitoring a condition of a battery according to claim 6 of the present invention is specified in the battery condition monitor as claimed in claim 5 in that the dischargeable capacity detector obtains the dischargeable capacity, whenever the battery is discharged, based on a ratio of a first changing value of the open-circuit voltage of a new battery against reduction of the charging condition of the battery caused by discharging and a second changing value of the open-circuit voltage of the battery against reduction of the charging condition of the battery caused by discharging, and the value of subtracting.

The battery condition monitor for monitoring a condition of a battery according to claim 7 of the present invention is specified in the battery condition monitor as claimed in any one of claims 4, 5 and 6 in that the dischargeable capacity detector obtains the dischargeable capacity based on a value by subtracting a voltage drop by the internal resistance when a peak current flows in discharging.

A battery condition monitoring method of monitoring a condition of a battery according to claim 8 includes the step of monitoring a capacity not to be discharged caused by an internal resistance of the battery as a capacity not to be discharged from the battery.

A battery condition monitoring method of monitoring a condition of a battery according to claim 9 includes the step of monitoring the condition of the battery based on a dischargeable capacity corresponding to a value of subtracting a capacity not to be discharged caused by an internal resistance of the battery from a charged capacity of the battery.

A battery condition monitoring method of monitoring a condition of a battery according to claim 10 includes the step of monitoring the condition of the battery based on a charged capacity of the battery, and a dischargeable capacity corresponding to a value of subtracting a capacity not to be discharged caused by an internal resistance of the battery from the charged capacity.

A battery condition monitoring method of monitoring a condition of a battery according to claim 11 includes the step of obtaining the dischargeable capacity based on a value of subtracting a voltage drop caused by the internal resistance during discharging from an open-circuit voltage corresponding to a charged capacity of the battery.

BRIEF DESCRIPTION OF THE DRAWINGS

Fig. 1 is a block diagram of one embodiment of a battery condition monitor performing a method of detecting a dischargeable capacity and a method of monitoring a battery condition according to the present invention;

Fig. 2 is a graph showing one example of a discharge current with a rush current at starting of driving a starter motor;

Fig. 3 is a graph showing an example of characteristics of I-V by an approximate quadratic equation;

Fig. 4 is a graph showing an example of method of deleting a part by concentration polarization from an approximate equation of increasing;

Fig. 5 is a graph showing an example of a method of deleting a part by concentration polarization from an approximate equation of decreasing;

Fig. 6 is a graph showing an example of characteristics of I-V by an approximate linear equation of increasing;

Fig. 7 is a graph showing an example of the other method of deleting a part by concentration polarization from an approximate equation of decreasing;

Fig. 8 is a graph showing an example of a furthermore method of deleting a part by concentration polarization from an approximate equation of decreasing;

Fig. 9 is a graph for explaining a method of obtaining a saturated polarization in discharging in a balanced condition or a condition having discharging polarization;

Fig. 10 is a graph for explaining a method of obtaining a saturated polarization in discharging in a condition having charging polarization;

Fig. 11 is a graph for explaining a method of obtaining a saturated polarization in discharging in a condition having discharging polarization or charging polarization;

Fig. 12 is a graph for explaining parts of voltage drop generated in the battery in discharging;

Fig. 13 is a graph for explaining a voltage at full-charge and a voltage at the end of discharge;

Fig. 14 is a graph for explaining a method of calculating the dischargeable capacity counting deterioration by obtaining a ratio of change of an open-circuit voltage corresponding to a change of any charge condition of the battery at ant time against a new battery;

DESCRIPTION OF THE PREFERRED EMBODIMENT

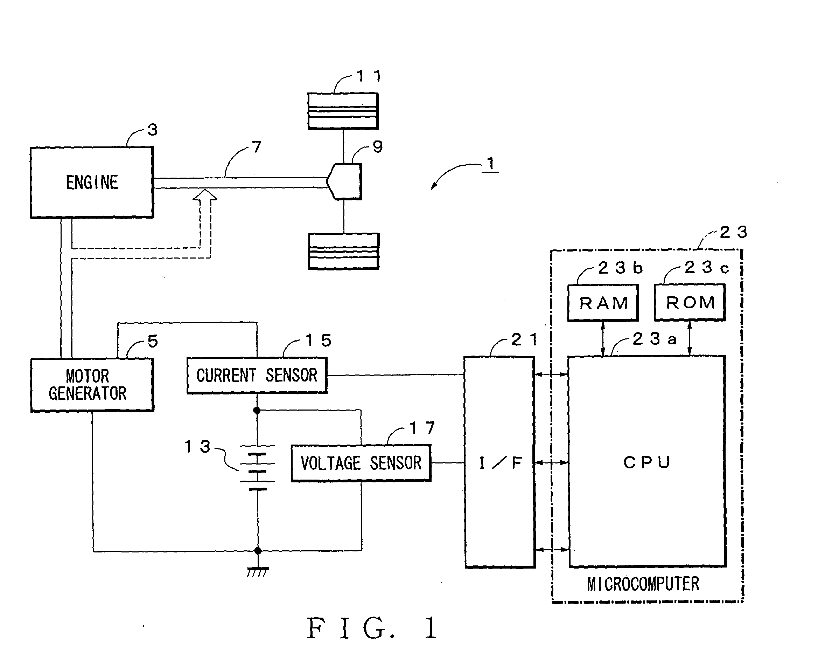

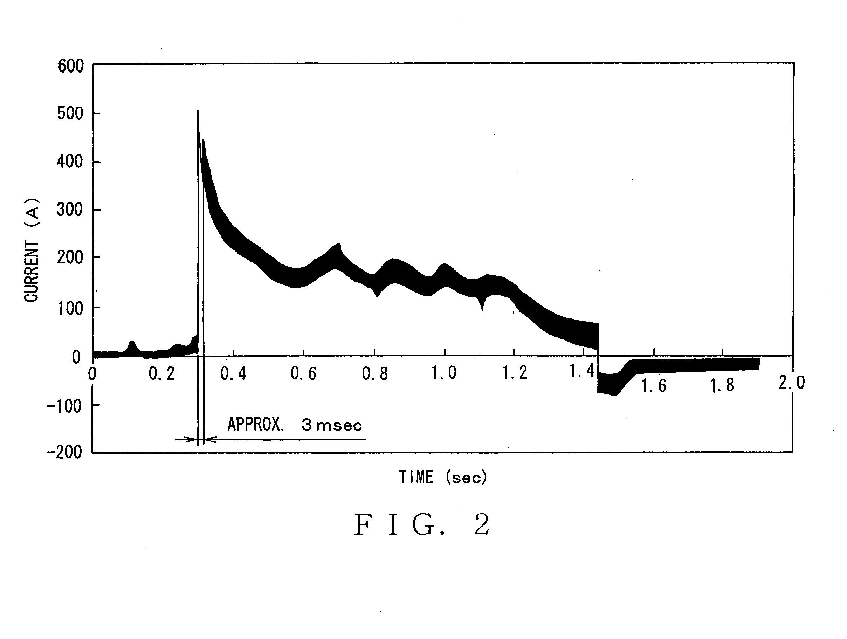

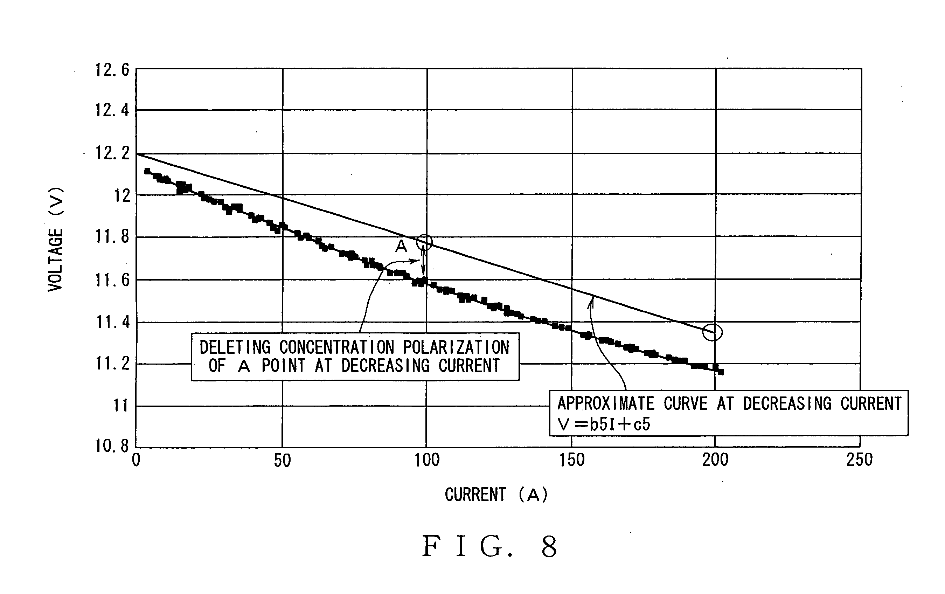

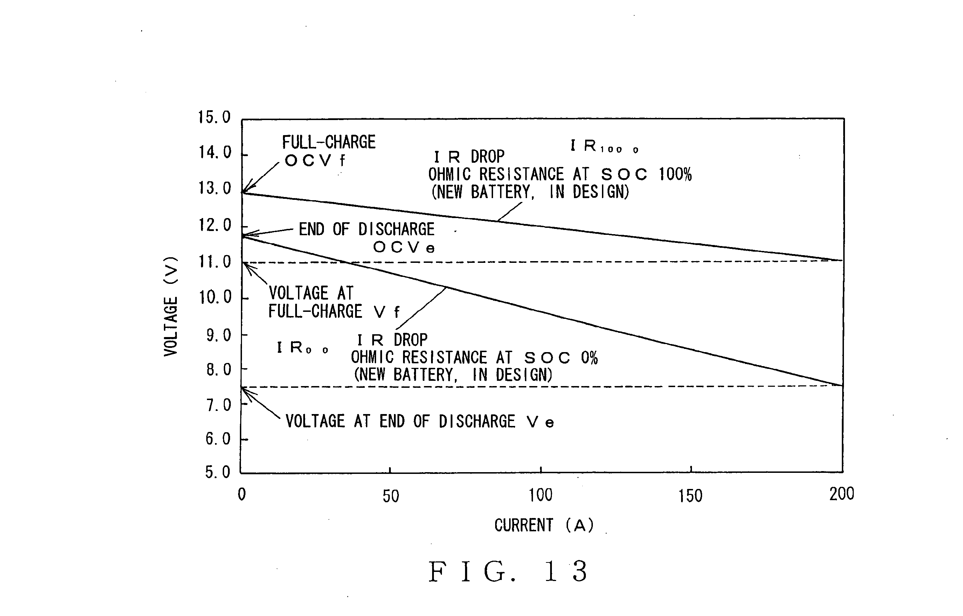

Before describing a battery condition monitor and a method of monitoring a battery condition, and a method of detecting a dischargeable capacity of a battery according of the present invention with reference to Fig. 1, a calculating method of a voltage drop caused by an internal resistance of the battery with reference to Figs. 2-14 will be described.

In a 12V car, a 42V car, an EV car and an HEV car having a battery, a constant load such as a starter motor, a motor generator and a drive motor, which requires large current, is installed as a vehicle load acting by supplied power from the battery. When a large current constant load like the starter motor is turned ON, after a rush current flows in the constant load, a constant current corresponding to a value of the load flows. When the load is a lamp, the rush current is called an inrush current.

When a direct-current motor is applied to the starter motor, the rush current flowing in a field coil increases from zero to a peak value as few times large as that of the constant current, for example 500 [A] , monotonously in a short time such as 3 msec. just after starting driving the constant load as shown in Fig. 2. After that, the current decreases from the peak value to the constant value corresponding to the constant load monotonously in a short time such as 150 msec. Thus, the current is supplied as a discharge current by the battery. Therefore, by measuring the discharge current of the battery and a terminal voltage corresponding to the discharge current when the rush current flows in the constant load, characteristics of the discharge current (I) of the battery and the terminal voltage (V) , which shows a change of the terminal voltage against a wide-range change of the current from zero to the peak value, can be measured.

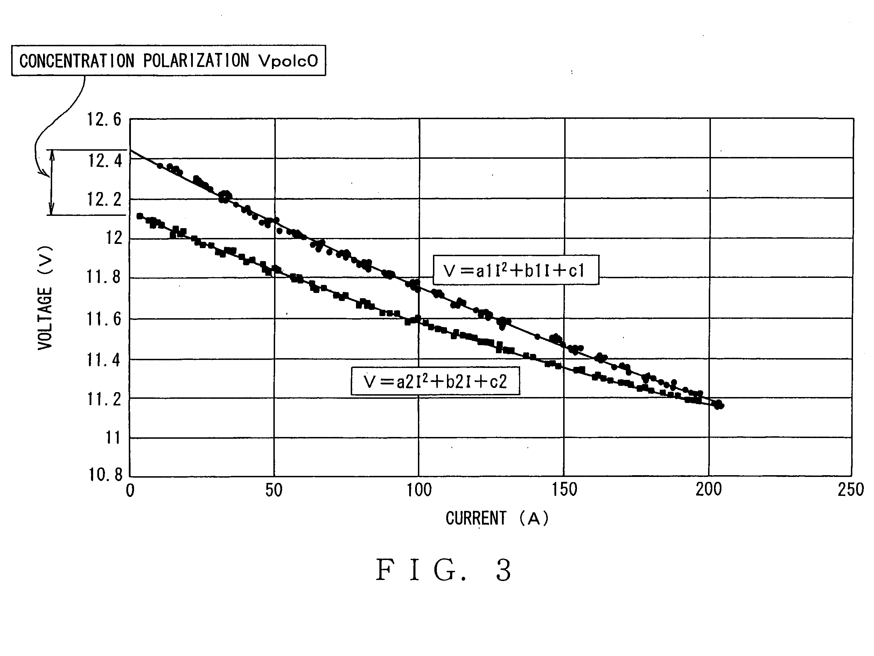

The battery is discharged by an electronic load, in which the current increases from zero to 200 [A] in 0.25 sec. and decreases from the peak value to zero in the same time, as a approximated discharge corresponding to the rush current flowing when the starter motor is turned ON. By measuring a pair of the discharge current of battery and the terminal voltage in a short constant period, and plotting the measured pair of data to correspond the discharge current to a horizontal axis and the terminal voltage to a vertical axis, a graph shown in Fig. 3 is given. The characteristics of the current-voltage in increasing and decreasing discharge current shown in Fig. 3 can be approximated to flowing quadratic equations by a least squares method.

$$V = a1*I^2 + b1*I + c1 \tag{1}$$

$$V = a2*I^2 + b2*I + c2 \tag{2}$$

In Fig. 3, curves of approximated quadratic equations are drawn to overlap on.

In Fig. 3, a voltage difference (c1-c2) between an intersection point of the approximated curve of increasing current and an intersection point of the approximated curve of decreasing current is a voltage difference at no current of zero [A]. Then, the voltage difference is considered as a voltage drop caused only by a part by the concentration polarization newly occurred by discharging, not including the direct-current resistance and the activation polarization. Therefore, the voltage difference (c1-c2) is caused only by the concentration polarization, and the concentration polarization at the current of zero [A] is called Vpolc0. Any concentration polarization is considered as a value of multiplying a current value and a time of current flowing together, which is in proportion to A*h (or A*sec because of short time)

A method of calculating a concentration polarization at the peak current by using the concentration polarization at the current of zero [A] Vpolc0 will be described. The concentration polarization at the peak current is called Vpolcp. Vpolcp is shown by the following equation.

$$Vpolcp = [(A*sec\ at\ increasing\ current)/(A*sec\ at\ total$$

$$time\ for\ discharging)] * Vpolc0 \tag{3}$$

A*sec at total time for discharging is shown by the following equation.

$$A*sec\ at\ total\ time\ for\ discharging = (A*sec\ at\ increasing$$

$$current + A*sec\ at\ decreasing\ current)$$

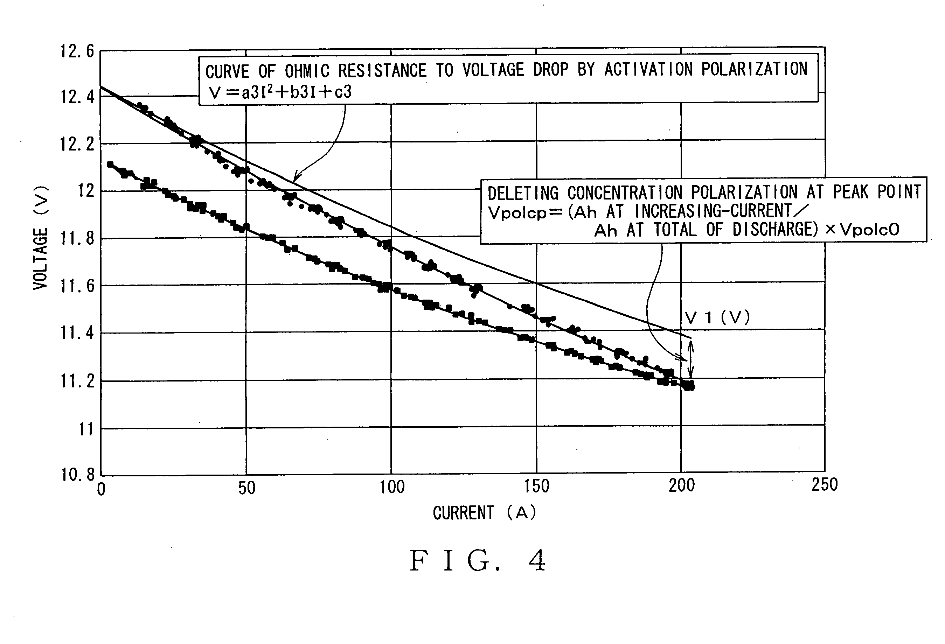

By adding the concentration polarization Vpolcp at the peak value as calculated above to the voltage at the peak value of increasing current of equation (1), the part by the concentration polarization at peak value is deleted as shown in Fig. 4. A voltage after deleting the part by the concentration polarization at peak value is called V1. V1 is shown in the following equation.

$$V1 = a1*Ip^2 + b1*Ip + c1 + Vpolcp$$

Ip is the current at the peak value.

An approximate equation of the characteristics of current-voltage of the direct-current resistance and the activation polarization as shown in Fig. 4 is tentatively shown as the following equation.

$$V = a3*I^2 + b3*I + c3 \tag{4}$$

Since the activation polarization and the concentration polarization at the current of zero [A] before start of discharging is considered based on c1, c3=c1 is given by the equation (1). Assuming that the current increases rapidly from an initial condition of increasing the current, but reaction of the concentration polarization is slow and the reaction is almost not proceeded, differential values of the equations (1) and (4) at the current of zero [A] becomes equal to each other so that b3=b1 is given. Therefore, by substituting c3=c1 and b3=b1, the equation (4) will be rewritten as the followings.

$$V = a3*I^2 + b1\ I + c1 \tag{5}$$

a3 is the only unknown quantity.

After that, assigning a coordinate of the peak of increasing current to the equation (5) , and straightening it about a3, the following equation can be given.

$$a3 = (V1 - b1*Ip - c1)/Ip^2 \tag{5}$$

Thus, the approximate equation of the current-voltage characteristics only by the direct-current resistance and a part by the activation polarization is given by the equation (5).

Usually, the direct-current resistance is not generated by a chemical reaction, so that it is constant if the charging condition of battery (SOC) and temperature are not changed. The resistance is constant while the initial driving of the start motor. On the other hand, the activation polarization is a resistance generated by a chemical reaction during exchanging ions and electrons. The activation polarization and the concentration polarization affect to each other, so that the current increasing curve and the current decreasing curve of the activation polarization are not completely accordant with each other. Therefore, the equation (5) can be considered as a curve of increasing current of the direct-current resistance and the activation polarization excluding the part by the concentration polarization.

A method of deleting the part by the concentration polarization from the decreasing current curve will be described as follows. An equation of decreasing current of the direct-current resistance and the activation polarization can be given by the same method of deleting the concentration polarization at the current peak value. Defining two points other than the peak value as points A and B, concentration polarization VpolcA, VpolcB at the points A and B is given by the following equations.

$$VpolcA = [(A*sec\ from\ start\ of\ increasing\ current\ to\ point$$

$$A)/(A*sec\ at\ total\ time\ for\ discharging)] * Vpolc0 \tag{6}$$

$$VpolcB = [(A*sec\ from\ start\ of\ increasing\ current\ to\ point$$

$$B)/(A*sec\ at\ total\ time\ for\ discharging)] * Vpolc0 \tag{7}$$

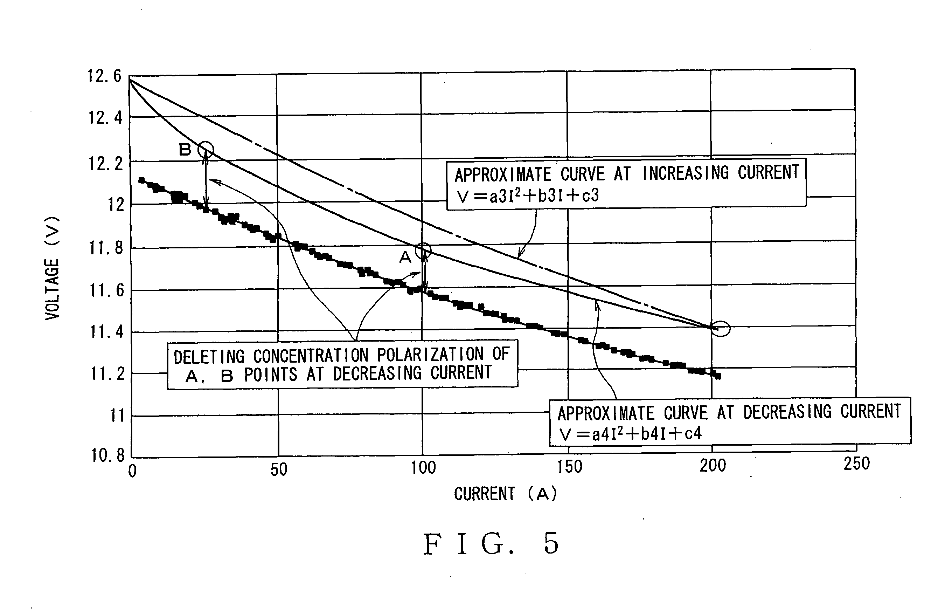

By using coordinates of three point of two points of deleting the part by concentration polarization other than the peak value given by the above equations (6), (7), and the peak value, a curve of decreasing current of the direct-current and the activation polarization shown by the following equation is given as shown in Fig. 5.

$$V = a4*I2 + b4*I + c4 \tag{8}$$

Coefficients a4, b4, c4 in the equation (8) can be determined by solving three simultaneous equations by assigning the current values and the voltages of the three points of points A, B and the peak point into the equation (8).

A method of calculating the direct-current resistance of the battery will be described. A difference between the curve of increasing current of the direct-current resistance and activation polarization excluding the concentration polarization shown by the above equation (5), and the curve of decreasing current of the direct-current resistance and activation polarization excluding the concentration polarization shown by the above equation (8) is according to the difference of the part by the activation polarization. Therefore, by deleting the part by the activation polarization from the above curves, the direct-current resistance can be given.

Watching the peak value of the both curves those the activation polarization is the same value to each other, a differential value R1 of increasing current and a differential value R2 of decreasing current at the peak value are given by the following equations.

$$R1 = 2*a3*Ip + b3 \tag{10}$$

$$R2 = 2*a4*Ip + b4 \tag{11}$$

A difference between the differential values R1 and R2 is caused by that one is the peak value of increasing of the activation polarization and the other is the peak value of decreasing. When the battery is discharged by using the electronic load to discharge as increasing from zero to 200 A within 0.25 sec and decreasing from the peak value to zero within the same time as a approximated discharge corresponding to the rush current, the both rates of change in the vicinity of the peak value are equal to each other, and it is considered that the characteristics of current-voltage by the direct-current resistance exists between the both. Therefore, by adding the differential values and dividing that by 2, the direct-current resistance R can be given by the following equation (in this example, a value of dividing proportionally the both differential value by a ratio of time and a value divided by 2 are the same).

$$R = (R1 + R2)/2$$

A case that the battery is discharged by using the electronic load as the approximated discharge corresponding to the rush current is described above. In case of actual vehicle, during the rush current flows in the field coil, the current reaches up to the peak, and cranking is acted by a current decreased down under the half of the peak current after reaching peak.

Therefore, the increasing current finishes in a short time of 3 msec. Such rapid current change almost never generate the concentration polarization at the peak value of the increasing current. The decreasing current flows in a long time of 150 msec comparing with the increasing current, so that, although decreasing current, a large concentration polarization is generated. During cranking, different phenomenon other than that during the rush current flows occurs. Discharge current and terminal voltage of the battery during cranking are not applied as data to determine the characteristics of current-voltage of decreasing current.

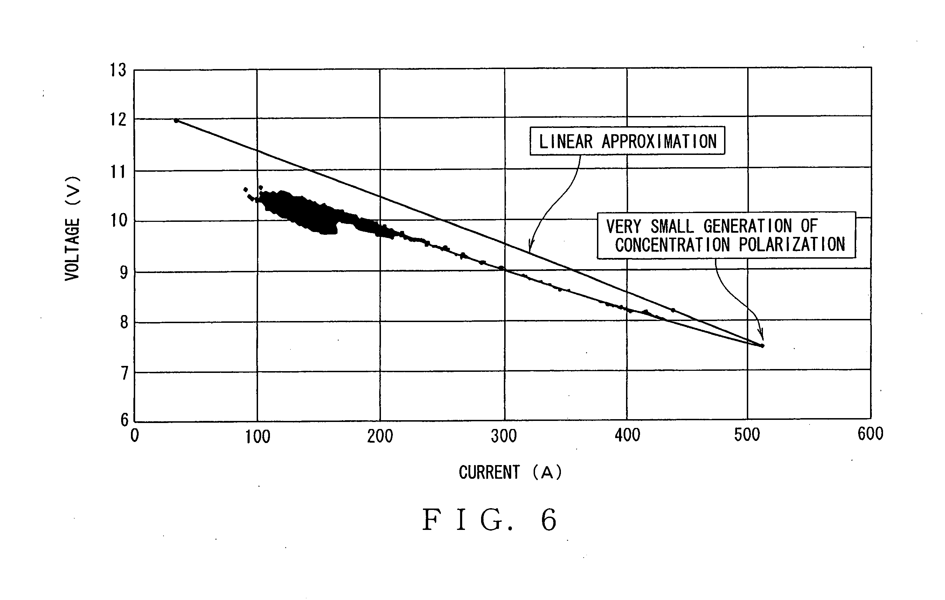

In such condition, the increasing current in the actual vehicle can be approximated by a straight line made with two points of a start point of increasing current and a peak value, as shown in Fig. 6. Generated value of the concentration polarization at the peak value of 500 [A] can be judged as zero [A]. In this case, a differential value at the peak value of increasing current uses a gradient of the approximated line of the increasing current.

In this case, a simple arithmetic average of the gradient of the approximated line of the increasing current and a gradient of a tangential line at the peak point of the approximated quadratic equation of the decreasing current cannot be applied. In such condition, generation of the concentration polarization completely differs between to-peak and after-peak, so that an assumption that the both ratios of change at the peak value are the same is not realized.

The direct-current resistance in this case is obtained by multiplying respectively change values per a unit of a current change of two terminal voltages at points corresponding to peak values of the first and second change values excluding the voltage drop by the concentration polarization, those are gradients, and ratios of times of monotonously increasing and monotonously decreasing against the total time of rush current flowing, and adding the results. In short, proportional ratios those are distributed by the monotonously increasing time against the total time and the monotonously decreasing time against the total time are multiplied with the each gradient and the result are added. Thereby, compensating an effect caused to each other by the activation polarization and the concentration polarization, the direct-current resistance can be obtained.

The activation polarization is generated in principal to have a value corresponding to the current. However, The value is affected by an amount of the concentration polarization, so that the value is not generated in principal. The smaller concentration polarization makes the activation polarization smaller, and the larger concentration polarization makes the activation polarization larger. In any case, the middle value between two changes per a unit of current-change of the terminal voltages at the points corresponding to the peak values of the two approximate equations excluding the voltage drop by the part by the concentration polarization can be measured as the direct-current resistance of the battery.

In a recent vehicle, an AC motor such as a magnet motor and a brushless DC motor, which requires a three-phase input power is used more frequently. In such motor, the rush current does not reach a peak value in a short time. It requires approximate 100 msec and the concentration polarization is generated in creasing current. Therefore, as same as the simulated discharging mentioned above, the current change curve of the increasing current must be approximated with a curve.

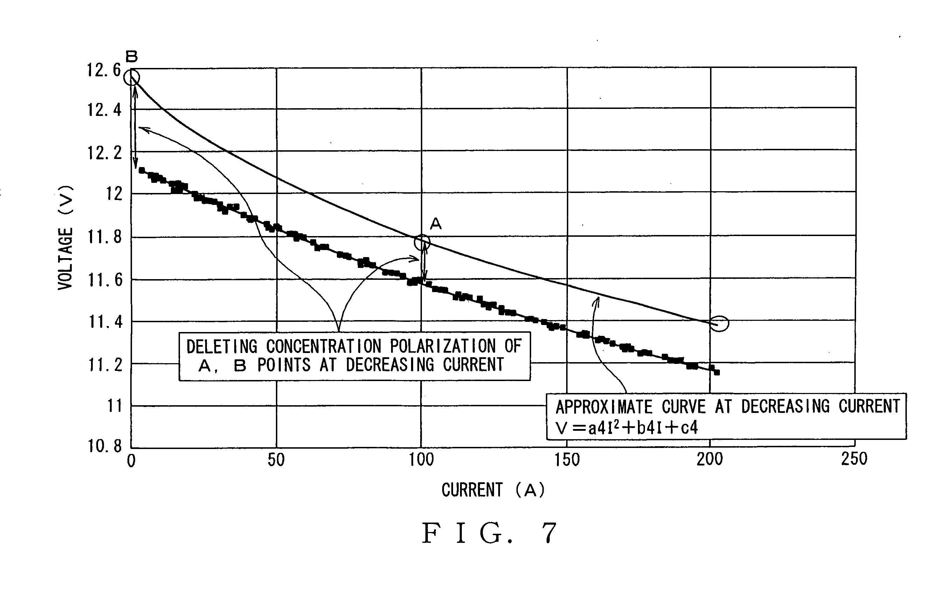

When approximating the direct-current resistance and the activation polarization at the decreasing current, for defining the peak value and two points other than the peak by applying the point of the current of zero [A] as the point B as shown in Fig. 7, calculation to obtain the approximate equation can be simplified.

If defining a point, a current of which is approximately half of the peak current, as a point where the concentration polarization is deleted, it can be linearly approximated to a straight line made by this point and the peak value. In this case, regarding the decreasing current, the gradient of the approximated straight line at the decreasing current is used as the differential value at the peak value. The direct-current resistance can be obtained accurately as same as that by using the quadratic curve.

In short, the middle value between two changes per the unit of current-change of the terminal voltages at the points corresponding to the peak values of the two approximate equations excluding the voltage drop by the part by the concentration polarization can be measured as the direct-current resistance of the battery.

In the case of using for example the starter motor, where a rush current flowing with generating the concentration polarization at the both of increasing discharging current and decreasing discharging current as the constant load, the method of measuring the direct-current resistance of the battery mounted on the vehicle will be described physically.

When the constant load is acted, the discharge current increasing monotonously over a steady-state value to peak value, and decreasing monotonously form the peak value to the steady-state value flows from the battery. The discharge current and the terminal voltage of the battery at the time are sampled at intervals of for example 100 microsec to measure them periodically, so that many couples of the discharge current and the terminal voltage are obtained.

The latest couple of the discharge current and the terminal voltage of the battery obtained above are stored, memorized and collected in a memory as rewritable storage device such as a RAM in a predetermined time. By the least-squares method, from couples of the discharge current and the terminal voltage stored, memorized and collected in the memory, two curved approximate equations (1) and (2) regarding to the characteristics of current-voltage of increasing discharging current and decreasing discharging current which show a relation between the terminal voltage and the discharging current. By deleting the voltage drop of the part by concentration polarization from the two approximate equations, an amended curved approximate equations excluding the part by the concentration polarization.

The voltage difference of the approximate equations (1) and (2) at the current of zero [A], flowing no current, is obtained as the concentration polarization, not as the voltage drop by the direct-current resistance and the activation polarization. The voltage drop of the part by concentration polarization at the peak value at the approximate equation (1) of characteristics of current-voltage of the increasing discharging current is obtained with the voltage difference. For that, the fact that the concentration polarization changes by a product of current-time, which is given by multiplying a value of current and a time of current flowing, is used.

After the voltage drop of the part by concentration polarization at the peak value at the approximate equation (1) of characteristics of current-voltage of the increasing discharging current is obtained, the constant and the coefficient of a leaner term of the approximate equation including the part of the concentration polarization are made the those of the approximate equation not including the part respectively the same. A coefficient of a quadratic term of the approximate equation not including the part is defined by that. Thereby, the amended curved approximate equation (5) of the approximate equation of the characteristics of current-voltage of the increasing discharging current is obtained.

After that, the approximate equation not including the part of concentration polarization will be given by the approximate equation (2) of the characteristics of current-voltage of the decreasing the discharging current. For that, two points deleting the part of the concentration polarization other than the peak value are obtained. For that, the fact that the concentration polarization changes by a product of current-time, which is given by multiplying a value of current and a time of current flowing, is used. When two points deleting the part by concentration polarization other than the peak value are obtained, the amended curved approximate equation (8), which is the approximate equation (2) of characteristics of current-voltage of the decreasing current amended by using three coordinates of the two points and the peak value is obtained. The difference between the amended curved approximate equation, shown by equation (5), of the increasing current of the direct-current resistance and the activation polarization by deleting the part by the concentration polarization and the amended curved approximate equation, shown by equation (8) , of the decreasing current of the direct-current resistance and the activation polarization by deleting the part by the concentration polarization is caused by the part by activation polarization. Therefore, the direct-current resistance can be given by deleting the part by the activation polarization. The difference between the differential values at the peak values of the increasing current and the decreasing current is caused by that the activation polarization of one is increasing and that of the other is decreasing. By watching the peak values of the both approximate equations, At a middle point between ratios of changes of the both in the vicinity of the peak value, the characteristics of current-voltage by the direct-current resistance exits. Therefore, the direct-current resistance can be obtained by multiplying the both differential values and respectively the time ratio in increasing monotonously and the time ratio in decreasing monotonously, and adding the results.

For example, assuming that the time of the increasing current is 3 msec, and the time of the decreasing current is 100 msec, and defining the differential value of the increasing current at the peak value as Rpolk1, and the differential value of the decreasing current at the peak value as Rpolk2, the direct-current resistance Rn can be calculated as follows.

$$Rn = Rpolk1*100/103 + Rpolk2*3/103$$

The direct-current resistance Rn is calculated and renewed whenever a high efficient discharge generating rush current is acted for example, each time when driving the start motor.

The terminal voltage of the battery measured in a balanced condition which effects of polarization generated in the battery by previous discharge is eliminated completely and the voltage down or up of the terminal voltage of the battery is eliminated completely, or an estimated value by the result of detecting a change of the terminal voltage of the battery just after stopping charging/discharging in a short time range is used as the voltage at open-circuit of the battery for the vehicle at the balanced condition of the battery is used.

A method of detecting a saturated polarization of the battery and the method of detecting dischargeable capacity according to the present invention will be described.

An energy of the battery to be discharged actually for a load is a capacity by subtracting a capacity corresponding to the voltage drop generated in the battery during discharging, that is the capacity to be not dischargeable by the internal resistance of the battery, from the charged capacity (product of the current and the time) corresponding to the value of open-circuit voltage of the battery.

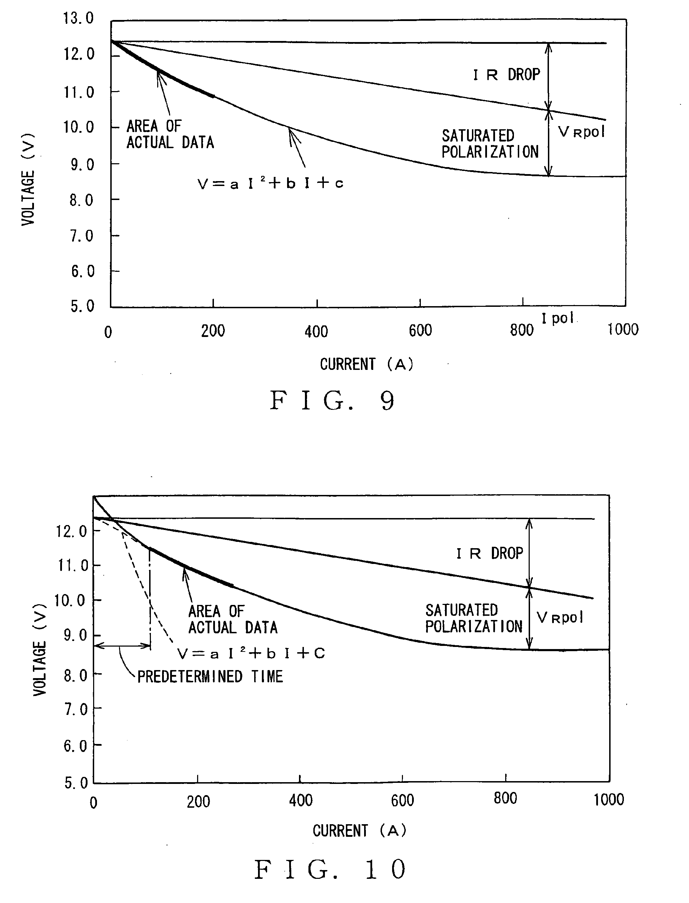

The voltage drop generated in the battery during discharging can be divided to a part of the voltage drop (IR drop shown in Figure) by the direct-current resistance of the battery and a part of the voltage drop by the other internal resistance than the direct-current resistance, that is a part of the voltage drop by polarization (saturated polarization shown in Figure) as shown in Fig. 9. The above IR drop is not changed when the battery is in the same condition. On the other hand, the voltage drop by the polarization enlarges proportionally with the discharge current or discharge time, but becomes not over the saturated polarization. Therefore, by monitoring a point of approaching the saturated polarization, a point of most increasing the voltage drop by the internal resistance can be monitored.

When the battery, which is in the balanced condition or in a condition of which the terminal voltage at staring discharge has a discharge polarization lower than an open-circuit voltage OCV0 at starting discharge, is discharged, an approximate equation of the terminal voltage V against the discharge current I shown by equation (12) is obtained by the discharge current and the terminal voltage of the battery measured in intervals within a predetermined period (appearing polarization and within 1 sec) from the starting discharge, as a wide line shown in Fig. 9.

On the other hand, when the battery, which is in a condition of which the terminal voltage at staring discharge has a discharge polarization larger than the open-circuit voltage OCV0 at starting discharge, is discharged, an approximate equation of the terminal voltage V against the discharge current I shown by equation (12) is obtained by the discharge current and the terminal voltage of the battery measured in intervals within a predetermined period when the predetermined period passes from the starting discharge to eliminate the discharge polarization, as a wide line shown in Fig. 10. The approximate equation obtained by the discharge current and the terminal voltage of the battery measured in intervals within a period when the discharge polarization exists has almost no relation between the actually obtained characteristics of the discharge current I and the terminal voltage V when discharging from the balanced condition.

$$V = a*I^2 + b*I + c \tag{12}$$

The above terminal voltage V of the battery can be also shown as follows by the sum of a part of the voltage drop by the direct-current resistance Rn and a part of the voltage drop $V_R$ (voltage drop by polarization) by the internal resistance other than the part by the direct-current resistance.

$$V = c - (Rn*I + V_R) \tag{13}$$

The following equation can be led from the equations (12) and (13).

$$a*I + B*I = -(Rn*I + V_R) \tag{14}$$

By differentiating the above equation (14), the change ratio $dV_R/dI$ of the voltage drop by internal resistance other than the direct-current resistance of the battery can be obtained.

$$dV_R/dI = -2a*I - b - Rn \tag{15}$$

When the above change ratio $dV_R/dI$ becomes to zero, the discharge current corresponds to a saturated current of the terminal voltage drop Ipo1 (= -(Rn + b)/2a) when the part by internal resistance other than the direct-current resistance of the battery becomes the maximum value (the saturated value).

When the discharge is from the balanced condition, by assigning the obtained saturated current of the terminal voltage drop Ipo1 as the discharge current I and the direct-current resistance Rn together into the equation (14), an obtained voltage drop $V_R$ (= -a*Ipol$^2$ - b*Ipol - Rn*Ipol) by polarization is defined as a saturated polarization $V_R$pol.

On the other hand, when discharge is from the condition in which the charge polarization or the discharge polarization exists, by assigning the obtained saturated current of the terminal voltage drop Ipo1 as the discharge current I and the direct-current resistance Rn together into the equation (14), a value by adding the obtained voltage drop $V_R$ by polarization and the terminal voltage c at the discharge current of zero obtained by the equation (12) and the obtained difference between the open-circuit voltage OCV0 at starting discharge (= -a*Ipol$^2$ - b*Ipol - Rn*Ipol + (OCV0 - c)) is defined as a saturated polarization $V_R$pol.

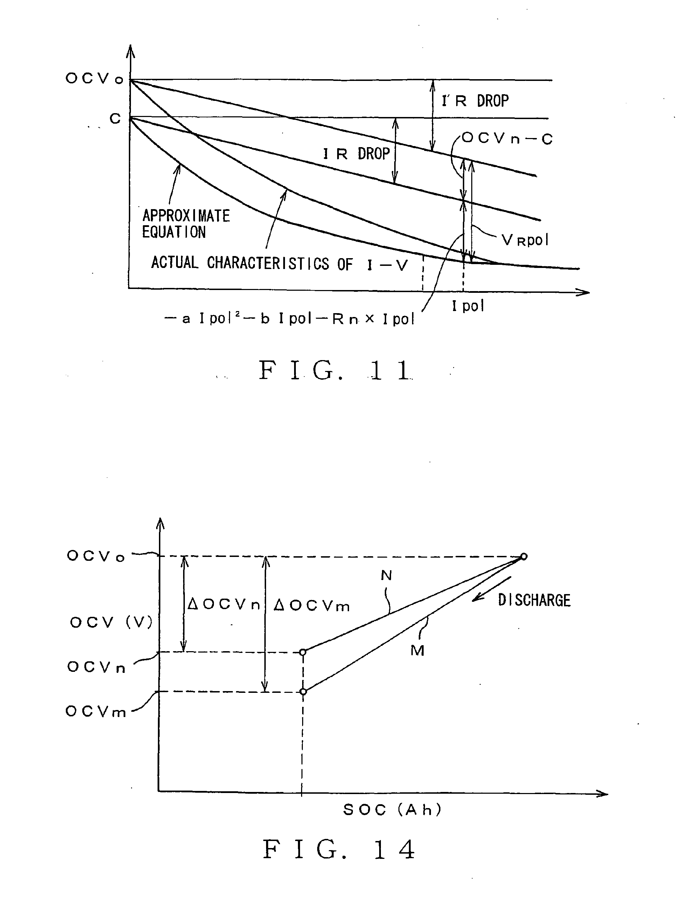

The reason of adding (OCV0 - c) mentioned above will be explained as follows. The terminal voltage at the discharge current of zero is shown in Fig. 11 to be given by the obtained approximate equation (12) based on the discharge current and the terminal voltage measured from the condition of remaining the charge polarization or the discharge polarization within the above predetermined period. As shown in Fig. 11, the saturated value of the voltage drop obtained by the approximate equation is equal to the saturated value of the voltage drop of the characteristics of the current I and the voltage V actually given after discharging from the balanced condition.

Even if the discharge is in the condition of remaining the charge polarization, by setting a predetermined time passing after discharging as the predetermined period, the terminal voltage c at the discharge current of zero obtained by the approximate equation is a lower value than the open-circuit voltage at the start of discharge OCV0.

At the time, the voltage drop of polarization obtained by assigning Ipol to the equation (14), $V_R$ (= -a*Ipol$^2$ - b*Ipol - Rn*Ipol) , is equal to a value of subtracting the voltage drop by the direct-current resistance Rn*Ipol from the voltage drop based on the terminal voltage c. Therefore, for obtaining the saturated polarization Vpol, as the value of subtracting the voltage drop by the direct-current resistance Rn*Ipol from the voltage drop of the battery, from the open-circuit voltage OCV0, it is required to add (OCV0 - c) to the above voltage drop $V_R$ (= -a*Ipol$^2$ - b*Ipol - Rn*Ipol). The $V_R$pol is calculated and renewed at every discharge of the battery.

After obtaining the saturated polarization $V_R$pol, the dischargeable capacity can be detected by every discharge, which requires to detect again the dischargeable capacity of the battery, by using the saturated polarization $V_R$pol, as described below.

When discharging, the saturated polarization $V_R$pol is obtained as mentioned above in the discharging, and a following equation is solved.

$$V_{ADC} = OCV0 - Rn*Ip - V_Rpol \tag{16}$$

herein, $V_{ADC}$ is a voltage indicating the present dischargeable capacity and Ip is the peak current of the discharge.

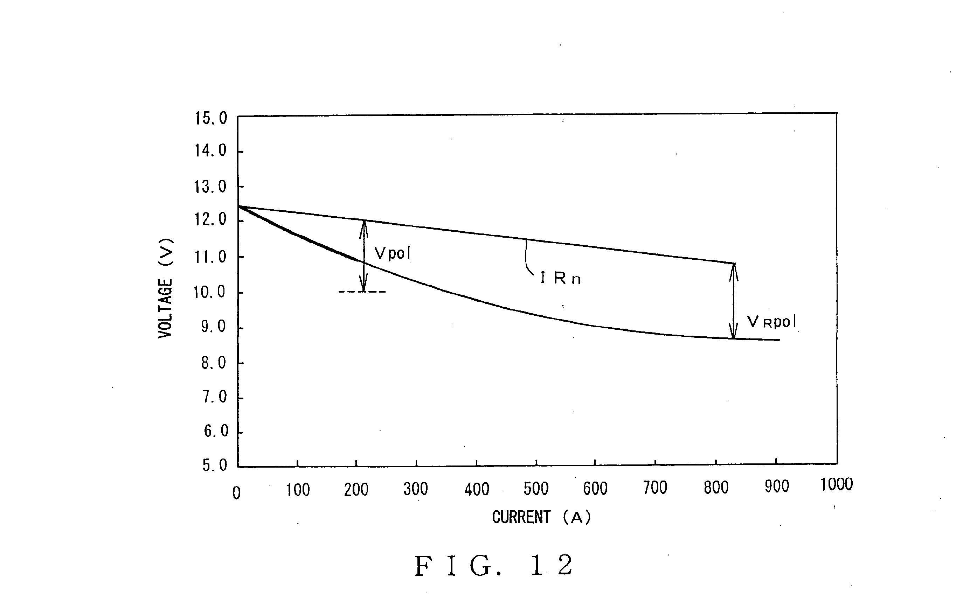

Solving the above equation means to obtain the voltage $V_{ADC}$ corresponding to a present dischargeable capacity of the battery ADC by subtracting the voltage drop corresponding to the direct-current resistance of the battery and the saturated polarization $V_R$pol from the open-circuit voltage of the battery at the start of discharge OCV0, as shown in Fig. 12.

From the voltage indicating the present dischargeable capacity $V_{ADC}$ obtained above, the dischargeable capacity ADC is given by a following converting equation in a voltage system.

$$ADC = SOC*\{(V_{ADC} - Ve)/(Vf - Ve)\}*100 \ [\%]$$

herein

$$SOC = \{(OCVn - Ve)/(Vf - Ve)\}*100 \ [\%]$$

Vf is a voltage at a full-charge, and Ve is a voltage at the end of discharge.

The voltage at the full-charge Vf is given by the following equation of subtracting a voltage drop corresponding to the direct-current resistance at the full-charge (SOC:State Of Charge=100%) of a new battery Rnf0 from the open-circuit voltage at the full-charge (SOC=100%) of a new battery OCVf.

$$Vf = OCVf - Rnf0*Ip$$

The voltage at the end of discharge Ve is given by the following equation of subtracting a voltage drop corresponding to the direct-current resistance at the end of discharge (SOC=0%) of a new battery Rne0 from the open-circuit voltage at the end of discharge (SOC=0%) of a new battery OCVe.

$$Ve = OCVe - Rne0*Ip$$

From the voltage indicating the present dischargeable capacity $V_{ADC}$ obtained above, the dischargeable capacity ADC can be given by the following converting equation in a voltage system.

$$ADC = SOC*\{(V_{ADC} - OCVe)/(OCV0 - Rne0*Ip - OCVe)\}*100\%$$

In the voltage drop corresponding to the direct-current resistance of the battery, which is subtracted from the open-circuit voltage of the battery at the start of discharge OCVn, differences of characteristics between each battery is reflected. In the present saturated polarization of the battery $V_R$pol, dispersion of decreasing of the dischargeable capacity ADC caused by flowing the discharge current and dispersion of decreasing of the dischargeable capacity ADC caused by change of the internal resistance by temperature change are reflected.

Therefore, the dischargeable capacity to be obtained at discharge ADC obtained above is accurate dischargeable capacity ADC excluding errors by an effect of differences of characteristics between each battery and effects of dispersion of decreasing of the dischargeable capacity ADC caused by flowing the discharge current and dispersion of decreasing of the dischargeable capacity ADC caused by change of the internal resistance by temperature change.

As mentioned above, the voltage drop by the internal resistance at the peak current in discharge, that is the voltage drop by the internal resistance at a time when the voltage drop by the direct-current resistance of the internal resistance other than the polarization becomes in the maximum, can be obtained.

As shown in Fig. 14, when discharging a battery in any open-circuit voltage OCV0 before discharge, the open-circuit voltage of the new battery decreases along a straight line N in proportion to proceeding of discharge until the open-circuit voltage OCVn at end of discharge to discharge any electric charge. The open-circuit voltage of a deteriorated battery decreases along a straight line M until the open-circuit voltage OCVm at the time to discharge the same electric charge.

Usually, after repeating discharge, the charge condition SOC can be estimated by a product of the current and the time. The charge condition can be calculated by summing the product of the current and the time at discharge as following equation.

SOC0 just before discharge - Σ ((discharge current)*time)

Whenever the battery is in discharge, the SOC of the battery can be estimated by the above equation.

As mentioned above, by always obtaining the estimated SOCn in discharge, and estimating the last SOCn at end of discharge when discharge is stopped, the estimated value is converted to an estimated OCVn. The conversion of the SOCn to OCVn is acted based on an initial electric charge as the total chargeable electric charge between the open-circuit voltage at full-charge and the voltage at end of discharge predetermined for the new battery.

A change rate ΔOCVn (=OCV0 - estimated OCVn) as a difference between the open-circuit voltage before discharge OCV0 and the above estimated OCVn is a change rate for calculation of the open-circuit voltage of the new battery against decrease of the charge of the battery by discharge.

A change rate ΔOCVm (=OCV0 - estimated OCVm) as a difference between the open-circuit voltage before discharge OCV0 and the OCVm measured after discharge or estimated is a change rate of the open-circuit voltage of the present battery against decrease of the charge of the battery by discharge.

Even if the battery is in the balanced condition or not, by multiplying ΔOCVn/ΔOCVm, a ratio of the change rate ΔOCVn and the change rate ΔOCVm to a right-hand side of the converting equation in the voltage system for obtaining the dischargeable capacity ADC from the voltage indicating the present dischargeable capacity $V_{ADC}$, the converting equation for obtaining the dischargeable capacity ADC from the voltage indicating the present dischargeable capacity $V_{ADC}$ will be as following.

$$ADC = \{(V_{ADC} - Ve) / (Vf - Ve)\}*(\Delta OCVn/\Delta OCVm)*100 \ [\%]$$

or

$$ADC = SOC*\{(V_{ADC} - OCVe) / (OCVn - Rne0*Ip - OCVe)\} *$$

$$(\Delta OCVn/\Delta OCVm)* 100\%$$

Thereby, even if inactivation exists in an active material of the battery, a more accurate dischargeable capacity can be obtained by counting the change of the open-circuit voltage OCVn corresponding to the change of charge condition by the inactivation.

Modification of the converting equation of obtaining the dischargeable capacity ADC from the voltage indicating the present dischargeable capacity $V_{ADC}$ for corresponding to a change of a ratio of amounts of the activation material and $H_2O$ of the battery can be eliminated.

As mentioned above, the value of adding the voltage drop by polarization $V_R$ (= -a*Ipol$^2$ - b*Ipol - Rn*Ipol) obtained by assigning Ipol to the equation (14) for obtaining the saturated polarization at discharge from the condition of remaining the charge polarization or the discharge polarization and (OCV0 - c) is defined as the saturated polarization. Even if the polarization is remained, and the battery is in the balanced condition or not, to obtain the voltage drop by polarization $V_R$ (= -a*Ipol$^2$ - b*Ipol - Rn*Ipol) given by assigning Ipol to the equation (14) as the saturated polarization, the voltage $V_{ADC}$ can be calculated by subtracting (OCV0 - c) from the open-circuit voltage OCV0.

The method of calculating the dischargeable capacity of the battery for the vehicle and the method of monitoring the battery condition according to the present invention are performed in a structure shown in Fig. 1.

Fig. 1 is a block diagram of one embodiment of a battery condition monitor to perform the method of calculating the dischargeable capacity and the method of monitoring the battery condition according to the present invention. The battery condition monitor of the embodiment shown with mark 1 in Fig. 1 is installed in a hybrid vehicle with a motor generator 5 added on an engine 3.

In the hybrid vehicle, an output power of the engine 3 is transmitted from a drive shaft 7 through a differential case 9 to a wheel 11 for normal driving. At high load condition, the motor generator 5 is performed as a motor by electric power of a battery 13 and an output of the motor generator 5 added on the output of the engine 3 is transmitted from the drive shaft 7 to the wheel 11 for assist driving.

In the hybrid vehicle, the motor generator 5 is performed as a generator at decelerating and breaking to convert kinetic energy to electric energy for charging the battery 13 installed in the hybrid vehicle for supplying electric power to various loads.

The motor generator 5 is used as a self-starting motor to rotate a flywheel of the engine 3 forcibly when the engine 3 is started by turning a starter switch (not shown) ON.

The battery condition monitor 1 includes a current sensor 15 for detecting a discharge current I of the battery 13 for the motor generator 5 performing as the motor of assist driving and the self-starting motor and a charging current from the motor generator 5 as a generator to the battery 13, and a voltage sensor 17 connected in parallel with the battery 13 to have an infinitely large resistance for detecting a terminal voltage of the battery 13.

The current sensor 15 and the voltage sensor 17 mentioned above are provided in a circuit to be closed by turning an ignition switch ON.

The battery condition monitor 1 includes a microcomputer 23 in which outputs of the current sensor 15 and the voltage sensor 17 are inputted after A/D converted at an interface circuit 21 (shown by I/F hereafter).

The microcomputer 23 has a CPU 23a, a RAM 23b, a ROM 23c. The RAM 23b, the ROM 23c and the I/F 21 are connected with the CPU 23a, and a signal of ON/OFF of the ignition switch (not shown) is inputted into the CPU 23a.

The RAM 23b has a data area for storing various data and a work area to be used for various processing work. In the ROM 23c, a control program to make the CPU 23a operate various processing is stored.

SOC and ADC of the battery 13 is detected by the microcomputer 23 performing various detection at discharge mentioned above based on the outputs of the current sensor 15 and the voltage sensor 17. Thus, the microcomputer 23 performs as detectors for detecting charge capacity and detecting dischargeable capacity.

As mentioned above, electric charge in the battery can be monitored by the charge capacity and the capacity to be actually used within the charge capacity in the battery can be monitored by the dischargeable capacity. Therefore, the battery condition can be monitored securely.

Thus, by monitoring respectively SOC and ADC, the battery condition monitor 1 can be applied to various usage of apparatuses in which the battery 13 is used.

For example, in a vehicle, SOC is indicated for back-up of an apparatus requiring a dark current. ADC is used for an engine starter to start the starter motor.

SOC can be used for detecting the chargeable capacity and estimating deterioration. ADC can be used for restarting engine (idling stop), a by-wire (steering, throttling and breaking) and assist driving.

In the embodiment, the dischargeable capacity is obtained by subtracting the voltage drop by the internal resistance when the voltage drop of the terminal voltage by polarization generated in discharging is saturated. The present invention does not limit the above, and the dischargeable capacity can be obtained by subtracting the voltage drop by the internal resistance before the voltage drop of the terminal voltage by polarization generated in discharging is saturated.

EFFECT OF INVENTION

As mentioned above, according to the present invention as claimed in claim 1, a capacity not to be discharged by an internal resistance from a battery can be monitored, so that a battery condition monitor which can monitor securely the battery condition and a method thereof can be provided.

According to the present invention as claimed in claim 2, the battery condition can be monitored based on a dischargeable capacity to be actually used within charge capacity in the battery, so that the battery condition monitor which can monitor securely the battery condition can be provided.

According to the present invention as claimed in claim 3, an electric charge can be monitored by the charge capacity and the capacity to be actually used within the charge capacity in the battery can be monitored by the dischargeable capacity, so that the battery condition monitor which can monitor securely the battery condition can be provided.

According to the present invention as claimed in claim 4, the battery condition monitor which can detect easily the dischargeable capacity to be actually used within charge capacity in the battery can be provided.

According to claim 5 of the present invention, when the dischargeable capacity is obtained based on the terminal voltage of the battery by the open-circuit voltage of the battery and the voltage drop caused by the internal resistance, the changing value of a characteristics of a charging condition of the battery and the open-circuit voltage caused by deterioration can be counted in. Thereby, the battery condition monitor which can monitor the battery condition based on more accurate dischargeable capacity counting that inactivation exists in an activation material in the battery can be provided.

According to the present invention as claimed in claim 6, the first changing value is equal to a changing value for calculation of the open-circuit voltage of the new battery corresponding to the charging condition decreased by discharging. The second changing value is equal to a changing value, which is the estimated or measured value, of the open-circuit voltage of the battery corresponding to the charging condition decreased by discharging. If a ratio of an amount of an activating material for transferring charge and an amount of a water ($H_2O$) in an electrolyte of the battery is changed comparing with the ratio at the time when the battery was new, and the ratio of the change of the voltage at the open circuit against the change of the charging condition is increased, the ration of the first changing value and the second changing value is changed. Therefore, by obtaining the dischargeable capacity based on the ration of the first changing value and the second changing value, and the value of subtracting, the dischargeable capacity compensated for inactivation of the activating material of the battery can be obtained. Thereby, the battery condition monitor which can monitor the battery condition based on more accurate dischargeable capacity counting that inactivation exists in an activation material in the battery can be provided.

According to claim 7 of the present invention, since the dischargeable capacity is obtained by subtracting the voltage drop by the internal resistance at the peak current, that is the largest voltage drop in discharging, the battery condition can be monitored based on the smallest dischargeable capacity in discharging. Thereby, the battery condition monitor, which can monitor the battery condition based on more accurate dischargeable capacity counting that inactivation exists in an activation material in the battery, can be provided.

According to claim 8 of the present invention, the capacity not to be discharged caused by an internal resistance of the battery is monitored, so that a method of monitoring the battery condition, which can monitor securely the battery condition, can be provided.

According to claim 9 of the present invention, the condition of the battery can be monitored based on the dischargeable capacity to be actually useable within the charged capacity in the battery, so that a method of monitoring the battery condition, which can monitor securely the battery condition, can be provided.

According to claim 10 of the present invention, the electric charge in the battery can be monitored based on the charged capacity, and the capacity to be actually usable within the charged capacity in the battery can be monitored, so that a method of monitoring the battery condition, which can monitor securely the battery condition, can be provided.

According to claim 11 of the present invention, a method of monitoring the battery condition, which can detect easily the dischargeable capacity to be actually usable within the charge capacity in the battery, can be provided.

**Claims**

1. A battery condition monitor for monitoring a condition of a battery, monitoring a capacity not to be discharged caused by an internal resistance of the battery.

2. A battery condition monitor for monitoring a condition of a battery, comprising a dischargeable capacity detector for detecting a dischargeable capacity corresponding to a value of subtracting a capacity not to be discharged caused by an internal resistance of the battery from a charged capacity, and monitoring the condition of the battery based on said detected dischargeable capacity.

3. A battery condition monitor for monitoring a condition of a battery, comprising a charged capacity detector for detecting a charged capacity and a dischargeable capacity detector for detecting a dischargeable capacity corresponding to a value of subtracting a capacity not to be discharged caused by an internal resistance of the battery from the charged capacity of the battery, and monitoring the condition of the battery based on said detected charged capacity and said detected dischargeable capacity.

4. The battery condition monitor according to claim 2 or 3, wherein the dischargeable capacity detector obtains the dischargeable capacity based on a value of subtracting a voltage drop caused by the internal resistance during discharging from an open-circuit voltage at start of discharging corresponding to discharging the battery.

5. The battery condition monitor according to claim 4, wherein the dischargeable capacity detector obtains the dischargeable capacity by making allowance for a changing value of a characteristics of a charging condition of the battery and the open-circuit voltage caused by deterioration.

6. The battery condition monitor according to claim 5, wherein the dischargeable capacity detector obtains the dischargeable capacity, whenever the battery is discharged, based on a ratio of a first changing value of the open-circuit voltage of a new battery against reduction of the charging condition of the battery caused by discharging and a second changing value of the open-circuit voltage of the battery against reduction of the charging condition of the battery caused by discharging, and said value of subtracting.

7. The battery condition monitor according to any one of claims 4, 5 and 6, wherein the dischargeable capacity detector obtains the dischargeable capacity based on a value by subtracting a voltage drop by the internal resistance when a peak current flows in discharging.

8. A battery condition monitoring method of monitoring a condition of a battery comprising the step of monitoring a capacity not to be discharged caused by an internal resistance of the battery as a capacity not to be discharged from the battery.

9. A battery condition monitoring method of monitoring a condition of a battery comprising the step of monitoring the condition of the battery based on a dischargeable capacity corresponding to a value of subtracting a capacity not to be discharged caused by an internal resistance of the battery from a charged capacity of the battery.

10. A battery condition monitoring method of monitoring a condition of a battery comprising the step of monitoring the condition of the battery based on a charged capacity of the battery, and a dischargeable capacity corresponding to a value of subtracting a capacity not to be discharged caused by an internal resistance of the battery from the charged capacity.

11. A method of detecting a dischargeable capacity of a battery comprising the step of obtaining the dischargeable capacity based on a value of subtracting a voltage drop caused by the internal resistance during discharging from an open-circuit voltage corresponding to a charged capacity of the battery.

FIG. 1

F I G. 2

EP 1 610 139 A1

FIG. 3

CONCENTRATION POLARIZATION VpolcO

$V = a_1 I^2 + b_1 I + c_1$

$V = a_2 I^2 + b_2 I + c_2$

VOLTAGE (V)

CURRENT (A)

EP 1 610 139 A1

F I G. 4

APPROXIMATE CURVE AT INCREASING CURRENT
$V = a3I^2 + b3I + c3$

DELETING CONCENTRATION POLARIZATION OF
A, B POINTS AT DECREASING CURRENT

APPROXIMATE CURVE AT DECREASING CURRENT
$V = a4I^2 + b4I + c4$

FIG. 5

F I G. 6

EP 1 610 139 A1

F I G. 7

F I G.  8

FIG. 9

FIG. 10

$-a I pol^2 - b I pol - R n \times I pol$

FIG. 11

FIG. 14

FIG. 12

EP 1 610 139 A1

FIG. 13

## INTERNATIONAL SEARCH REPORT

| | International application No. |
|---|---|
| | PCT/JP2004/003913 |

**A. CLASSIFICATION OF SUBJECT MATTER**
Int.Cl$^7$ G01R31/36

According to International Patent Classification (IPC) or to both national classification and IPC

**B. FIELDS SEARCHED**

Minimum documentation searched (classification system followed by classification symbols)
Int.Cl$^7$ G01R31/36

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2004 |
| Kokai Jitsuyo Shinan Koho | 1971–2004 | Toroku Jitsuyo Shinan Koho | 1994–2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2003-68368 A (Nippon Telegraph And Telephone Corp.),<br>07 March, 2003 (07.03.03),<br>Full text; all drawings<br>(Family: none) | 1,8<br>2-7,9-11 |
| Y | JP 2000-147075 A (Denso Corp.),<br>26 May, 2000 (26.05.00),<br>Full text; all drawings<br>(Family: none) | 2-7,9-11 |
| Y | JP 2000-261901 A (Nissan Motor Co., Ltd.),<br>22 September, 2000 (22.09.00),<br>Full text; all drawings<br>(Family: none) | 5,6,11 |

| ☒ Further documents are listed in the continuation of Box C. | ☐ See patent family annex. |
|---|---|

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 11 June, 2004 (11.06.04) | 06 July, 2004 (06.07.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

| International application No. |
| --- |
| PCT/JP2004/003913 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 7-239372 A (Fujitsu Ltd.), 12 September, 1995 (12.09.95), Full text; all drawings (Family: none) | 7 |

Form PCT/ISA/210 (continuation of second sheet) (January 2004)